# EUROPEAN PATENT SPECIFICATION

(11) **EP 0 469 679 B1**
(45) Date of publication and mention of the grant of the patent: **19.03.1997**
(21) Application number: 91201961.9
(22) Date of filing: 26.07.1991
(51) Int. Cl.: H01J 37/141, H01J 37/147

(54) **Charged particle beam system, a cooling member, a coil comprising such cooling member and a cooling device incorporating such cooling member**
Ladungspartikelstrahlanlage, Kühlelement, eine Spule mit solch einem Kühlelement und ein Kühlvorrichtung, die ein derartiges Kühlelement aufweist
Système à faisceau de particules chargées, organe de refroidissement, bobine munie d'un tel organe de refroidissement et dispositif de refroidissement présentant un tel organe de refroidissement

(30) Priority: 02.08.1990 NL 9001751
(43) Date of publication of application: 05.02.1992
(73) Proprietor: Philips Electronics N.V., 5621 BA Eindhoven (NL)
(72) Inventor: Bakker, Johan Gustaaf, NL-5656 AA Eindhoven (NL); Asselbergs, Peter Emile Stephan Joseph, NL-5656 AA Eindhoven (NL)
(74) Representative: Bakker, Hendrik

(56) References cited:
- DE-A- 3 610 073
- DE-B- 1 614 407
- US-A- 4 611 330
- PATENT ABSTRACTS OF JAPAN vol. 10, no. 104 (E-397)(2161) 19 April 1986 & JP-A- 60 245 132

## Description

The invention relates to a charged particle beam system according to the preamble of claim 1.

The invention also relates to a cooling member, a coil comprising such cooling member and a cooling device incorporating such cooling member.

An electron lens of the kind set forth for use in a charged particle beam system is known from the Japanese patent abstract, vol. 10, no. 104, corresponding to JP-A-245132.

Because in this known device water circulates around the coil, an effective heat exchange is realised, the heat developed in the coil being transported directly by convection. Using such a cooling member the convection of the heat to the environment is reduced when use is made of this cooling device.

It is an object of the invention to enhance the cooling properties of such device. Thereto the charged particle beam system is characterised as defined in claim 1.

This object is also reached by a coding member according to claim 11.

By the shoulder which extends in a circumferential direction of the lid and which cooperates with the coil, it is attained that the cooling medium has a better controlled circulation, thus giving a better heat transfer to the cooling medium and reducing the risk of hot spots in the device and uncontrolled turbulences that would giver rise to undesired vibrations in the system.

An embodiment of a charged particle beam system in accordance with the invention is characterized in that the shoulder cooperates with an annular closing member which closes the inlet cavity and the outlet cavity in an end face situated opposite the bottom, which closing member comprises a plurality of inlet openings and outlet openings which are situated to both sides of the shoulder and also comprises a further shoulder which is situated between the inlet and outlet openings and which engages the coil.

The use of the closing member which is clamped between the lid and the coil enables suitable sealing of the cooling duct. A plurality of inlet and outlet openings in the closing member prevents turbulances during inlet and outlet of the cooling medium, so that disturbing vibrations in the coil are avoided.

A further embodiment of a charged particle beam system in accordance with the invention is characterized in that the cooling member comprises an axial flow space which is situated between the coil and the jacket and which forms part of the cooling duct, which flow space is substantially completely separated from the cooling duct in a circumferential direction of the jacket.

*Via* an inlet opening in the bottom of the jacket, cooling water can flow upwards along the coil in the space between the coil and the jacket, after which it leaves the chamber in the axial direction, *via* the flow space, through an outlet opening provided in the bottom of the jacket. The flow space can be formed by a tube provided between the jacket and the coil or by two axial shoulders which enclose the flow space in conjunction with a portion of the jacket, situated between the shoulders, and the coil. The discharging of the cooling medium *via* the flow space counteracts accumulation of air in the chamber and prevents image- disturbing vibrations.

A further embodiment of a charged particle beam system in accordance with the invention is characterized in that the cooling member is made of a plastics material.

The walls and the bottom of the cooling member are substantially not thermally conductive, as opposed to the known cooling members. As a result, the walls, the bottom and the lid can be made of a material having a low thermal conductivity coefficient such as plastics. The walls and the bottom are preferably formed as a single moulded product which may also include the closing member. The closing member is then connected to the walls at a number of points.

Another embodiment of a charged particle beam system in accordance with the invention is characterized in that the charged particle beam system comprises a cooling device with a closed circuit comprising a cooling liquid reservoir, the cooling member and a heat exchanging element which is situated, viewed in a flow direction, between the cooling liquid reservoir and the cooling member in order to cool the cooling liquid prior to its passage through the cooling member. When water is heated from 20° C to 30° C, the solubility of oxygen decreases from 13.810⁻⁴ mol 1⁻¹ to 10.310⁻⁴ mol 1⁻¹ and the solubility of nitrogen decreases from 6.8810⁻⁴ mol 1⁻¹ to 5.2710⁻⁴ mol 1⁻¹. The water heated in the cooling duct by the coil will be degassed due to the heating, so that an air bubble could be formed in the cooling duct. This causes undesirable turbulances in the flow pattern so that the coil may start to vibrate which has a negative effect on the image quality. In order to counteract this phenomenon, the cooling liquid in the heat exchanging element is cooled in the absence of air from, for example 27°C to 20°C. As a result, the cooling medium is capable of taking up more air but, because no air is present in the heat exchanging element, the cooling liquid will be undersaturated. If the water in the coil is not heated further than the temperature in the cooling medium reservoir (27°), no degassing will take place in the cooling member. Should air still be present in the cooling member when it is first put into operation, the air present can be removed in that the unsaturated cooling liquid absorbs the air.

A further embodiment of a charged particle beam system in accordance with the invention is characterized in that the cooling device comprises a further heat exchanging element which is situated, viewed in the flow direction, between the cooling member and the cooling liquid reservoir and which can be by-passed *via* a valve.

When the coil is not energized, the cooling liquid which has been cooled with respect to the reservoir is not heated in the cooling duct. When the coil is not energized, the heat extracted by the heat exchanging element situated between the cooling liquid reservoir and the cooling member is applied to the cooling liquid again *via* the further heat exchanging element. When the coil is energized, the further heat exchanging element is by-passed *via* the valve. The heat exchanging elements preferably form two heat exchangers in conjunction with heat exchanging elements included in a further closed circuit. The further closed circuit contains, for example, the cooling medium freon and includes, for example, a heat exchanger for giving off the heat in the further circuit.

Some embodiments of a charged particle beam system in accordance with the invention will be described in detail hereinafter with reference to the accompanying drawing. Therein:
Fig. 1 is a cross-sectional view of a charged particle beam system,
Fig. 2 is a cross-sectional view of a coil provided with a cooling member in accordance with the invention,
Fig. 3 shows a part of a cooling member in accordance with the invention,
Fig. 4a shows a cooling member provided with two axial shoulders,
Fig. 4b is a sectional view of a coil provided with a cooling member as shown in Fig. 4a, and
Fig. 5 shows a diagram of a cooling device for use in a charged particle beam system in accordance with the invention.

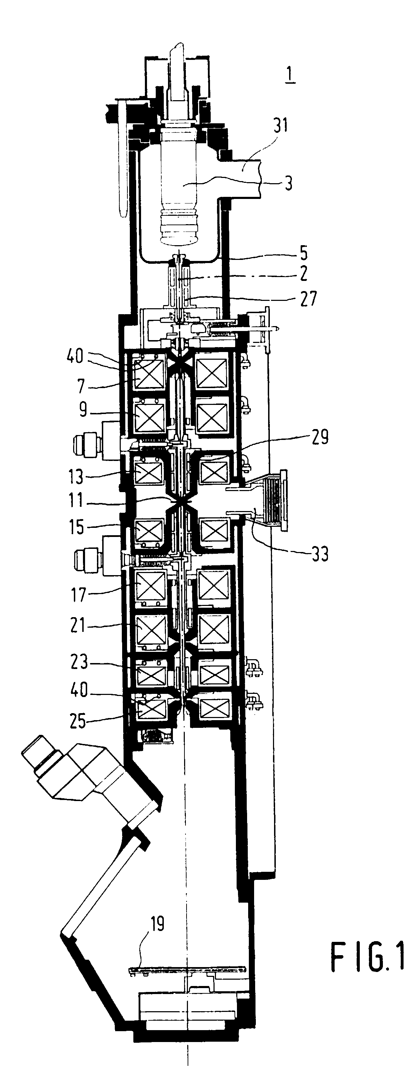

Fig. 1 shows a charged particle beam system 1, notably an electron microscope, comprising a source 3 and a focusing device which is formed by coils 7, 9, 13, 15, 17, 21, 23, 25 which are arranged along an optical axis 2. Electrons emitted by the source 3 are accelerated by an anode 5 and are projected, *via* a projection lens system 7, 9, on a specimen 11 which is situated in an objective lens 13, 15.

A diffraction image of the specimen 11 can be imaged on a target 19 by energizing a diffraction lens. The enlargement of the electron microscope can be adjusted by energizing an intermediate lens 21. A projection lens system 23, 25 projects the image formed by the lenses 15, 17 and 21 onto the target 19. Along the column there are also arranged source alignment coils 27 and beam tilting coils 29. *Via* pump connections 31 and 33, a system of vacuum pumps reduces a pressure in the electron microscope to, for example, 10⁻⁸ Torr. In the present embodiment, the lenses which dissipate, for example, a power of 500 W (200 kV, 2.5 mA) *via* 16000 ampère turns, are cooled in the customary manner. *Via* a cooling duct 40, the heat transferred to the cooling duct by conduction by the metal enclosing the lens is only partly carried off. A part of the heat, for example 30%, contributes to a heating of the surroundings of the lenses *via* convection or conduction. In order to counteract thermal drift in the specimen 11 to be examined and to enable the use of a high-power density of the lens so as to reduce spherical aberrations, the lenses 7, 9, 13, 15, 17, 21 and 23 are cooled to, for example, 22° C.

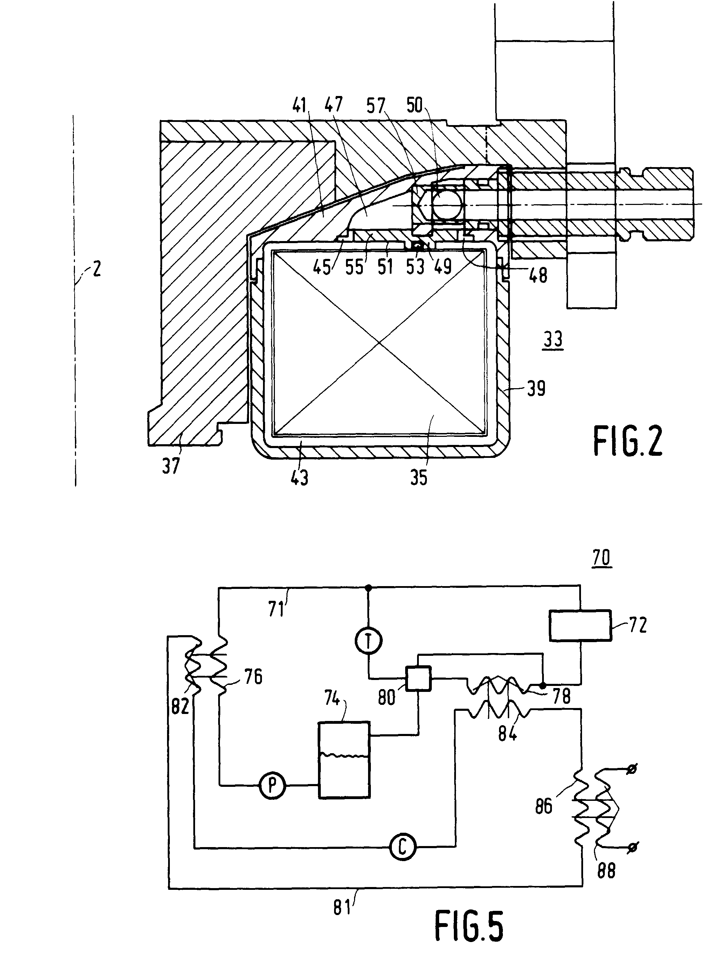

Fig. 2 shows the lens 33, be it only a part thereof which is situated to one side of the optical axis 2. The lens 33 comprises a toroidal coil 35 and a soft-iron pole shoe 37. The windings of the coil 35 are enclosed by a plastics jacket 39. The jacket 39 comprises a lid 41, a cooling duct 43 being arranged between the jacket 39 and the coil 35. *Via* cams (not shown in the Figure) the coil 35 bears on the bottom 45 of the jacket 39 so that the cooling medium can circulate around the coil 35. *Via* an inlet opening 45, the cooling medium supplied through an inlet cavity 47 in the lid 41 enters the cooling duct 43 and leaves the cooling duct 43 *via* an outlet opening 48 so as to be discharged through an outlet cavity 50 provided in the lid 41. The closing member 55, being situated in an end face 51 of the chamber enclosed by the jacket 39, is pressed against the coil 35 by the lid 41. The shoulder 49 bears on the coil 35 and seals the cooling duct 43 *via* an o-ring 53.

On the upper side of the closing member 55 there is provided a slot which is engaged by a shoulder 57 of the lid, said shoulder separating the inlet cavity 47 and the outlet cavity 49 provided in the lid 41.

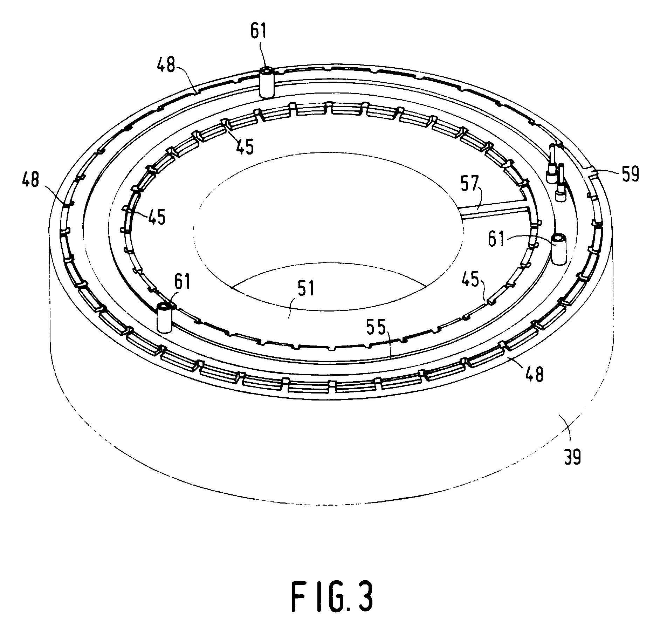

Fig. 3 shows the jacket 39 of the cooling member and the closing member 55 which is situated in the end face 51 and which is connected to the walls of the jacket 39 by way of fixing means 57 and 59. The walls and the bottom of the jacket 39 consist of a single moulded product. The closing member 55 is provided with inlet openings 45 and outlet openings 48 on an inner and an outer circumferential side. Using bushes 61, the lid 41 can be secured to the closing member 55 by means of screws.

When such a cooling member is used in the case of a voltage of 200 kV across the coil, a current density of 5 A mm⁻² can be used as opposed to a current density of 4 A mm⁻² as possible according to the known method for cooling the lenses.

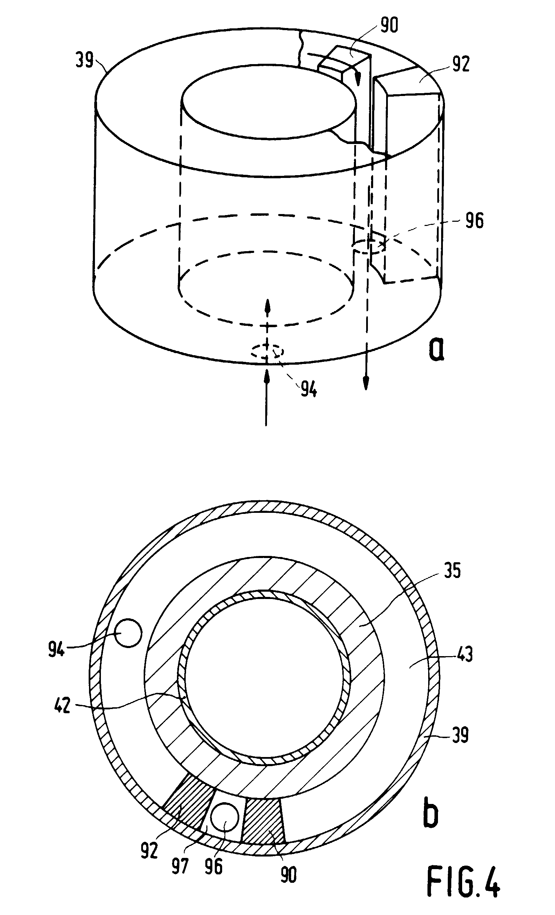

Figs. 4a and 4b show the jacket 39 of the cooling member, which jacket is provided with two axial shoulders 90 and 92 on the inner side. The cooling medium enters the cooling duct 43 *via* the inlet opening 94 situated adjacent the shoulders 90 and 92. Fig. 4a does not show the coil 35. After heating by the coil 35, the cooling medium flows to the outlet opening 96 situated between the shoulders 90 and 92. Instead of the shoulders 92 and 94, the flow space 97 can also be formed by a tube arranged between the coil 35 and the jacket 39.

Fig. 5 shows a cooling device 70 for cooling the coil surrounded by the cooling member 72. Air is liable to be released in the cooling duct 43 of the cooling member 72 when the cooling medium, for example water, is heated. The air bubbles disturb the flow of the cooling medium and may cause turbulances which may cause vibration of the lens 33. The deflection of the charged particle beam is thus disturbed, so that inaccurate imaging of an object illuminated by the electron beam takes place in the case of an electron microscope.

In order to prevent segregation of air from the cooling medium, a cooling liquid which is undersaturated with respect to air flows through the cooling member 72. The cooling device 70 comprises a cooling liquid reservoir 74 which is connected, *via* a pump P, to a first heat exchanging element 76. The heat exchanging element 76 is connected to the cooling member 72 whose outlet opening is connected to a second heat exchanging element 78. The second heat exchanging element 78 is connected to the liquid reservoir 74 and can be by-passed *via* a controllable valve 80. A further closed circuit 81 is formed by heat exchanging elements 82, 84 and 86 and the compressor C, the heat exchanging elements 82 and 84 cooperating with the heat exchanging elements 76 and 78, respectively, the heat exchanging element 86 forming part of a heat exchanger 88 for discharging the heat from the circuit 81. The cooling liquid temperature in the reservoir 74 is, for example 27°C. In the heat exchanging element 76 the cooling liquid is cooled to a temperature of 20°C in the absence of air, so that the cooling liquid will be undersaturated. When the cooling liquid is heated to a temperature below 27°C in the cooling member 72, no air will be released from the cooling liquid. Any air present in the cooling duct 43 of the cooling member 72 will be absorbed by the undersaturated cooling liquid. *Via* the by-passing of the heat exchanging element 78, the cooling liquid returns to the reservoir 74. The heat absorbed in the circuit 81 is given off *via* the heat exchanging element 86. If no power is dissipated in the coil, the cooling liquid is returned to the reservoir *via* the heat exchanging element 78, the heat extracted from the heat exchanging element 76 being applied to the circuit 71 again *via* the heat exchanging element 84. To achieve this, when the temperature in the circuit 71 drops excessively, the controllable valve 80 is activated *via* a temperature sensor T, so that the cooling liquid is heated *via* the heat exchanging element 84.

When a cooling member as shown in the Figs. 4a and 4b is used, the problem of air accumulation does not occur or only to a very small extent, so that the heat exchanging element 76 can then be dispensed with.

Charged particle beam systems covered by the present invention include scanning electron microscopes, transmission electron microscopes, electron beam writers and testers for semiconductor manufacture, electron or ion beam lithography devices and ion beam implantation devices.

## Claims

1. A charged particle beam system (1), comprising a source (3) for emitting a beam of charged particles and a focusing device (7, 9, 13, 15, 17, 21, 23, 25) which comprises at least one coil for deflecting the beam, said at least one coil comprising a cooling member which encloses the coil and which comprises a cooling duct (40) for transporting a cooling medium and a jacket (39) which forms a chamber having an inlet opening (45) and an outlet opening (48), the coil being accommodated in said chamber, the cooling duct comprising a space (97) between the coil and the jacket, the jacket comprising two concentric, cylindrical walls and a bottom which is connected to the walls,
characterized in that the jacket further comprises a detachable lid (41) which cooperates with the walls, said lid is provided with an inlet cavity (47) and an outlet cavity (50) which are separated from one another by a shoulder (49) which extends in a circumferential direction of the lid and which cooperates with the coil, the inlet opening and the outlet opening being situated one on each side of the shoulder.

2. A charged particle beam system as claimed in Claim 1, characterized in that the shoulder cooperates with an annular closing member which closes the inlet cavity and the outlet cavity in an end face situated opposite the bottom, which closing member comprises a plurality of inlet openings and outlet openings which are situated to both sides of the shoulder and also comprises a further shoulder which is situated between the inlet and outlet openings and which engages the coil.

3. A charged particle beam system as claimed in Claim 1 or 2, characterized in that the cooling member comprises an axial flow space which is situated between the coil and the jacket and which forms part of the cooling duct, which flow space is substantially completely separated from the cooling duct in a circumferential direction of the jacket.

4. A charged particle beam system as claimed in Claim 3, characterized in that on an inner side of the jacket there are provided two axial, neighbouring shoulders which engage the coil, the flow space being bounded by the shoulders, a portion of the jacket which is situated between the shoulders, and the coil.

5. A charged particle beam system as claimed in Claim 4, characterized in that the shoulders extend as far as the bottom of the jacket, the inlet opening being situated in a jacket portion situated adjacent the shoulders, the outlet opening being situated in a jacket portion situated between the shoulders.

6. A charged particle beam system as claimed in any one of the preceding Claims, characterized in that the cooling member is made of a plastics material.

7. A charged particle beam system as claimed in Claim 6, characterized in that the walls and the bottom are formed as a single moulded product.

8. A charged particle beam system as claimed in any one of the preceding Claims, characterized in that the charged particle beam system comprises a cooling device with a closed circuit (70) comprising a cooling liquid reservoir (74), the cooling member (72) and a heat exchanging element (76) which is situated, viewed in a flow direction, between the cooling liquid reservoir and the cooling member in order to cool the cooling liquid prior to its passage through the cooling member.

9. A charged particle beam system as claimed in Claim 8, characterized in that the cooling device comprises a further heat exchanging element (78) which is situated, viewed in the flow direction, between the cooling member and the cooling liquid reservoir and which can be by-passed *via* a valve (80).

10. A charged particle beam system as claimed in Claim 11, characterized in that the cooling device comprises a further closed circuit (81) which includes heat exchanging elements (82, 84 and 86) which cooperate with the heat exchanging elements in the closed circuit, and also comprises a heat exchanger (88) for giving off the heat in the further closed circuit.

11. A cooling member for enclosing a coil comprising:
- a cooling duct for transporting a cooling medium and
- a jacket which forms a chamber for accommodating said coil and having an inlet opening and an outlet opening,
- the cooling duct comprising a space between the coil and the jacket,
- the jacket comprising two concentric, cylindrical walls and a bottom which is connected to the walls,
characterized in that the jacket comprises a detachable lid which cooperates with the walls, said lid being provided with an inlet cavity and an outlet cavity which are separated from one another by a shoulder which extends in a circumferential direction of the lid and which cooperates with the coil, the inlet opening and the outlet opening being situated one on each side of the shoulder.

12. A coil comprising a cooling member according to claim 11.

13. A cooling device incorporating a cooling member according to claim 11.

## Patentansprüche

1. Ladungsteilchenstrahlsystem (1), mit einer Quelle (3) zum Emittieren eines Strahls von Ladungsteilchen und einer Fokussiervorrichtung (7, 9, 13, 15, 17, 21, 23, 25), die zumindest eine Spule zum Ablenken des Strahls umfaßt, wobei diese zumindest eine Spule ein Kühlelement umfaßt, das die Spule umschließt und das einen Kühlkanal (40) zum Transport eines Kühlmediums und einen Mantel (39) umfaßt, der eine Kammer mit einer Einlaßöffnung (45) und einer Auslaßöffnung (48) bildet, wobei die Spule in der genannten Kammer untergebracht ist, der Kühlkanal einen Raum (97) zwischen der Spule und dem Mantel umfaßt, der Mantel zwei konzentrische, zylindrische Wände und einen Boden umfaßt, der mit den Wänden verbunden ist, dadurch gekennzeichnet, daß der Mantel einen abnehmbaren Deckel (41) umfaßt, der mit den Wänden zusammenwirkt, wobei der genannte Deckel mit einem Einlaßhohlraum und einem Auslaßhohlraum versehen ist, die durch eine in einer Umfangsrichtung des Dekkels verlaufende Schulter, die mit der Spule zusammenwirkt, voneinander getrennt sind, wobei die Einlaßöffnung und die Auslaßöffnung an je einer Seite der Schulter liegen.

2. Ladungsteilchenstrahlsystem nach Anspruch 1, dadurch gekennzeichnet, daß die Schulter mit einem ringförmigen Verschlußelement zusammenwirkt, das den Einlaßhohlraum und den Auslaßhohlraum in einer gegenüber dem Boden liegenden Endfläche verschließt, wobei das Verschlußelement eine Vielzahl von Einlaßöffnungen und Auslaßöffnungen umfaßt, die zu beiden Seiten der Schulter liegen, und auch eine weitere Schulter umfaßt, die zwischen den Einlaß- und den Auslaßöffnungen liegt und in die Spule greift.

3. Ladungsteilchenstrahlsystem nach Anspruch 1 oder 2, dadurch gekennzeichnet, daß das Kühlelement einen axialen Strömungsraum umfaßt, der zwischen der Spule und dem Mantel liegt und der ein Teil des Kühlkanals ist, welcher Strömungsraum in einer Umfangsrichtung des Mantels nahezu vollständig vom Kühlkanal getrennt ist.

4. Ladungsteilchenstrahlsystem nach Anspruch 3, dadurch gekennzeichnet, daß an einer Innenseite des Mantels zwei axiale, benachbarte Schultern vorgesehen sind, die in die Spule greifen, wobei der Strömungsraum von den Schultern, einem zwischen den Schultern liegenden Abschnitt des Mantels und der Spule begrenzt wird.

5. Ladungsteilchenstrahlsystem nach Anspruch 4, dadurch gekennzeichnet, daß sich die Schultern bis zum Boden des Mantels erstrecken, wobei die Einlaßöffnung in einem neben den Schultern liegenden Mantelabschnitt liegt und die Auslaßöffnung in einem zwischen den Schultern liegenden Mantelabschnitt liegt.

6. Ladungsteilchenstrahlsystem nach einem der vorhergehenden Ansprüche, dadurch gekennzeichnet, daß das Kühlelement aus Kunststoff hergestellt ist.

7. Ladungsteilchenstrahlsystem nach Anspruch 6, dadurch gekennzeichnet, daß die Wände und der Boden als ein einziges Gußstück geformt sind.

8. Ladungsteilchenstrahlsystem nach einem der vorhergehenden Ansprüche, dadurch gekennzeichnet, daß das Ladungsteilchenstrahlsystem eine Kühlvorrichtung mit einem geschlossenen Kreis (70) umfaßt, der ein Kühlflüssigkeitsreservoir (74), das Kühlelement (72) und ein Wärmeaustauschelement (76) umfaßt, das in einer Strömungsrichtung gesehen zwischen dem Kühlflüssigkeitsreservoir und dem Kühlelement liegt, um die Kühlflüssigkeit zu kühlen, bevor sie das Kühlelement durchläuft.

9. Ladungsteilchenstrahlsystem nach Anspruch 8, dadurch gekennzeichnet, daß die Kühlvorrichtung ein weiteres Wärmeaustauschelement (78) umfaßt, das in der Strömungsrichtung gesehen zwischen dem Kühlelement und dem Kühlflüssigkeitsreservoir liegt und das über ein Ventil (80) umgangen werden kann.

10. Ladungsteilchenstrahlsystem nach Anspruch 9, dadurch gekennzeichnet, daß die Kühlvorrichtung einen weiteren geschlossenen Kreis (81) umfaßt, der Wärmeaustauschelemente (82, 84 und 86) enthält, die mit den Wärmeaustauschelementen in dem geschlossenen Kreis zusammenwirken, und auch einen Wärmeaustauscher (88) umfaßt, um die Wärme in dem weiteren geschlossenen Kreis abzugeben.

11. Kühlvorrichtung zum Umschließen einer Spule mit:
- einem Kühlkanal zum Transport eines Kühlmediums und
- einem Mantel, der eine Kammer, mit einer Einlaßöffnung und einer Auslaßöffnung, zum Unterbringen der Spule bildet,
- wobei der Kühlkanal einen Raum zwischen der Spule und dem Mantel umfaßt,
- wobei der Mantel zwei konzentrische, zylindrische Wände und einen Boden umfaßt, der mit den Wänden verbunden ist,
dadurch gekennzeichnet, daß der Mantel einen abnehmbaren Deckel umfaßt, der mit den Wänden zusammenwirkt, wobei der genannte Deckel mit einem Einlaßhohlraum und einem Auslaßhohlraum versehen ist, die durch eine in einer Umfangsrichtung des Dekkels verlaufende Schulter, die mit der Spule zusammenwirkt, voneinander getrennt sind, wobei die Einlaßöffnung und die Auslaßöffnung an je einer Seite der Schulter liegen.

12. Spule mit einem Kühlelement nach Anspruch 11.

13. Kühlvorrichtung, die ein Kühlelement nach Anspruch 11 enthält.

## Revendications

1. Système à faisceau de particules chargées (1) comportant une source (3) pour émettre un faisceau de particules chargées et un dispositif de focalisation (7, 9, 13, 15, 17, 21, 23, 25) qui comporte au moins une bobine pour la déviation du faisceau, ladite au moins une bobine comportant un organe de refroidissement qui renferme la bobine et qui comporte une canalisation de refroidissement (40) pour transporter un milieu de refroidissement et une chemise (39) qui constitue une chambre présentant une ouverture d'entrée (45) et une ouverture de sortie (48), la bobine étant incorporée dans ladite chambre, la canalisation de refroidissement comportant un espace (97) situé entre la bobine et la chemise, la chemise comportant deux parois concentriques cylindriques et un fond qui est relié aux parois, la chemise comporte encore un couvercle détachable (41) coopérant avec les parois, caractérisé en ce que ledit couvercle est muni d'une cavité d'entrée (47) et d'une cavité de sortie (50) qui sont séparées l'une de l'autre par un épaulement (49) s'étendant dans une direction circonférentielle du couvercle et coopérant avec la bobine, l'ouverture d'entrée et l'ouverture de sortie chacune étant percée de chaque côté de l'épaulement.

2. Système à faisceau de particules chargées selon la revendication 1, caractérisé en ce que l'épaulement coopère avec un organe de fermeture annulaire fermant la cavité d'entrée et la cavité de sortie dans une face terminale étant située à l'opposé du fond, ledit organe de fermeture comporte une pluralité d'ouvertures d'entrée et d'ouvertures de sortie qui sont situées des deux côtés de l'épaulement, et il comporte également un autre épaulement qui est situé entre les ouvertures d'entrée et de sortie et qui engage la bobine.

3. Système à faisceau de particules chargées selon la revendication 1 ou 2, caractérisé en ce que l'organe de refroidissement comporte un espace d'écoulement axial étant situé entre la bobine et la chemise et faisant partie de la canalisation de refroidissement, ledit espace d'écoulement est séparé d'une manière sensiblement complète de la canalisation de refroidissement s'étendant dans une direction circonférentielle de la chemise.

4. Système à faisceau de particules chargées selon la revendication 3, caractérisé en ce que le côté intérieur de la chemise est muni de deux épaulements axiaux contigus qui engagent la bobine, l'espace d'écoulement étant limité par les épaulements, par une partie de la chemise étant située entre les épaulements et par la bobine.

5. Système à faisceau de particules chargées selon la revendication 4, caractérisé en ce que les épaulements s'étendent jusqu'au fond de la chemise, l'ouverture d'entrée étant située dans une partie de chemise située d'une manière contiguë aux épaulements, l'ouverture de sortie étant située dans une partie de chemise située entre les épaulements.

6. Système à faisceau de particules chargées selon l'une quelconque des revendications précédentes, caractérisé en ce que l'organe de refroidissement est fabriqué à partir d'un matériau en plastique.

7. Système à faisceau de particules chargées selon la revendication 6, caractérisé en ce que les parois et le fond sont formés comme une pièce moulée unique.

8. Système à faisceau de particules chargées selon l'une quelconque des revendications précédentes, caractérisé en ce que le système à faisceau de particules chargées comporte un dispositif de refroidissement présentant un circuit fermé (70) comportant un réservoir de liquide de refroidissement (74), l'organe de refroidissement (72) et un élément d'échange de chaleur (76) qui est situé, vu dans une direction d'écoulement, entre le réservoir de liquide de refroidissement et l'organe de refroidissement de manière à refroidir le liquide de refroidissement avant qu'il ne traverse l'organe de refroidissement.

9. Système à faisceau de particules chargées selon la revendication 8, caractérisé en ce que le dispositif de refroidissement comporte un autre élément d'échange de chaleur (78) qui est situé, vu dans une direction d'écoulement, entre l'organe de refroidissement et le réservoir de liquide de refroidissement, et qui peut être ponté par l'intermédiaire d'une valve (80).

10. Système à faisceau de particules chargées selon la revendication 11, caractérisé en ce que le dispositif de refroidissement comporte un autre circuit fermé (81) incorporant des éléments d'échange de chaleur (82, 84 et 86) qui coopèrent avec les éléments d'échange de chaleur dans le circuit fermé, et en ce qu'il comporte également un échangeur de chaleur (88) pour dissiper la chaleur dans l'autre circuit fermé.

11. Organe de refroidissement pour incorporer une bobine comportant:
- une canalisation de refroidissement pour transporter un milieu de refroidissement et
- une chemise constituant une chambre pour incorporer ladite bobine, et présentant une ouverture d'entrée et une ouverture de sortie,
- la canalisation de refroidissement comportant un espace situé entre la bobine et la chemise,
- la chemise comportant deux parois concentriques cylindriques et un fond qui est relié aux parois,
caractérisé en ce que la chemise comporte un couvercle détachable coopérant avec les parois, ledit couvercle étant muni d'une cavité d'entrée et d'une cavité de sortie qui sont séparées l'une de l'autre par un épaulement s'étendant dans une direction circonférentielle du couvercle et coopérant avec la bobine, l'ouverture d'entrée et l'ouverture de sortie chacune étant située de chaque côté de l'épaulement.

12. Bobine comportant un organe de refroidissement selon la revendication 11.

13. Dispositif de refroidissement incorporant un organe de refroidissement selon la revendication 11.
